# EUROPEAN PATENT SPECIFICATION

(11) **EP 4 391 381 B1**
(45) Date of publication and mention of the grant of the patent: **08.04.2026**
(21) Application number: 22215810.7
(22) Date of filing: 22.12.2022
(51) Int. Cl.: H03K 17/10, H03K 17/61, H03K 17/691, H03K 17/723

(54) **SWITCHING DEVICE COMPRISING SERIALLY-CONNECTED SEMICONDUCTOR SWITCHES**
SCHALTGERÄT MIT SERIELL GESCHALTETEN HALBLEITERSCHALTERN
DISPOSITIF DE COMMUTATION COMPRENANT DES COMMUTATEURS À SEMI-CONDUCTEUR CONNECTÉS EN SÉRIE

(43) Date of publication of application: 26.06.2024
(73) Proprietor: Sécheron SA, 1242 Satigny (CH)
(72) Inventor: PRADERVAND, Christophe, 1350 Orbe (CH)
(74) Representative: Micheli & Cie SA

(56) References cited:
- EP-A2- 2 722 986
- US-A- 4 751 408
- US-A- 5 148 064
- US-B1- 7 072 196

## Description

The present invention relates to a switching device comprising semiconductor switches, such as thyristors, MOSFETs or IGBTs, connected in series.

For decades, semiconductor switches have been serially connected in order to increase the breakdown voltage of the semiconductor arrangement. Such an arrangement is challenging for the voltage distribution across all switches in series, as well as for the control.

Patent US 5,148,064 A for example describes a medium-voltage static switch comprising a series of power semiconductors controlled by a capacitive line. A diode is connected in parallel with each capacitor of the capacitive line between the gates of two adjacent semiconductors. The control voltage is applied to a single control input, between the gate and the source of the first-stage semiconductor, causing conduction of the first stage and then the upper stages.

Patent US 4,751,408 A describes a switch similar to the previous one in which the MOS transistors in series are also controlled by a capacitive line comprising a diode in parallel with each capacitor.

Thyristors are widely used in high-voltage electronics due to their ruggedness regarding surge current, intrinsic turn-off as well as reverse blocking capability. When thyristors are arranged in series, a parallel resistor and a parallel snubber are required at each stage for, respectively, static voltage balancing and dynamic balancing at turn-on as well as at turn-off. This topology needs a synchronous firing of all stages in order to avoid overvoltage stress on a specific stage. Firing techniques for serially-connected thyristors are described in the article "Firing Series SCRs at Medium Voltage: Understanding the Topologies Ensures the Optimum Gate Drive Selection", Power Systems World Conference, Chicago, Illinois, Oct. 31, 2002, with a summary of their advantages and limitations.

For example, when the triggering energy is provided by the voltage across each semiconductor switch, the switch can be triggered only when the voltage is present. This is disadvantageous in that the overall switching device cannot be tested and diagnosed for its correct switching behaviour without the presence of the high voltage.

Another example is when the triggering energy is provided from the control circuit by a transformer for each stage, which is a widely-used solution across the industry. In such a case, the insulation requirement of the transformers increases at each level.

The only ideal solution to address galvanic insulation limitation as well as perfect synchronisation is to use light-triggered thyristors controlled by optical fibres, but these thyristors are not available for all current capability ranges, are rather expensive and there is still the problem that the turn-on cannot be tested without the high voltage being present.

Another challenging topic in the realization of a high-voltage switching device is the overvoltage protection. It is usually implemented with an overvoltage detector that simply turns on the thyristor string to protect it, but there are special applications, typically in railways, where turning on during a lightning strike is not allowed, which requires the string to be protected by voltage limitation devices or designed to handle the voltage of the lightning strike.

The present invention aims to remedy the above-mentioned drawbacks, at least partly, and more particularly to provide a switching device comprising a string of serially-connected semiconductor switches which can be controlled in a simple manner without the need for a voltage to be present across the string.

To this end, there is proposed a switching device according to claim 1.

The invention also proposes methods for testing this switching device.

Particular embodiments of the invention are defined in the dependent claims.

Other features and advantages of the present invention will become apparent upon reading the following detailed description made with reference to the appended drawings in which:
- figure 1 shows a lower part of a switching device according to a first embodiment of the invention;
- figures 2a to 2c show the lower part of the switching device according to the first embodiment with a firing current circulating in it, at different times during the turning-on;
- figures 3a to 3c show an upper part of the switching device according to the first embodiment with a firing current circulating in it, at different times during the turning-on;
- figure 4 shows graphs of voltages and currents measured during the turning-on of the switching device according to the first embodiment, in the case where a voltage is present across the device;
- figure 5 shows graphs of voltages and currents measured during the turning-on of the switching device according to the first embodiment, in the case where no voltage is present across the device;
- figure 6 shows a switching device according to a second embodiment of the invention;
- figure 7 shows graphs of voltages and currents measured during the turning-on of the switching device according to the second embodiment, in the case where a voltage is present across the device;
- figure 8 shows graphs of voltages and currents measured during the turning-on of the switching device according to the second embodiment, in the case where no voltage is present across the device;
- figure 9 shows a lower part of a switching device according to a third embodiment not covered by the claims; and
- figure 10 shows a switching device according to a fourth embodiment not covered by the claims.

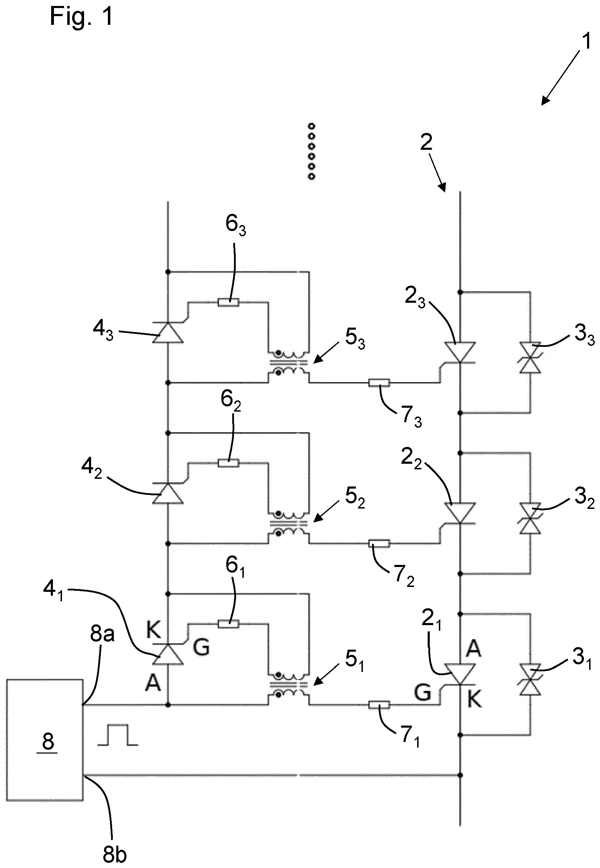

Referring to figure 1, a switching device 1 according to a first embodiment of the invention, particularly for medium or high voltage applications, comprises a number N of main thyristors 2₁ to 2_{N} connected in series to form a thyristor string 2. Each main thyristor 2ᵢ, where 1 ≤ i ≤ N, is protected against overvoltage by a protection device 3ᵢ connected in parallel to it, i.e., connected between the anode A and cathode K of the thyristor 2ᵢ. Each overvoltage protection device 3ᵢ preferably consists of one or more transient voltage suppressor diodes, as shown. Alternatively, it could consist of one or more Zener diodes, one or more metaloxide varistors or one or more silicon carbide varistors, for example.

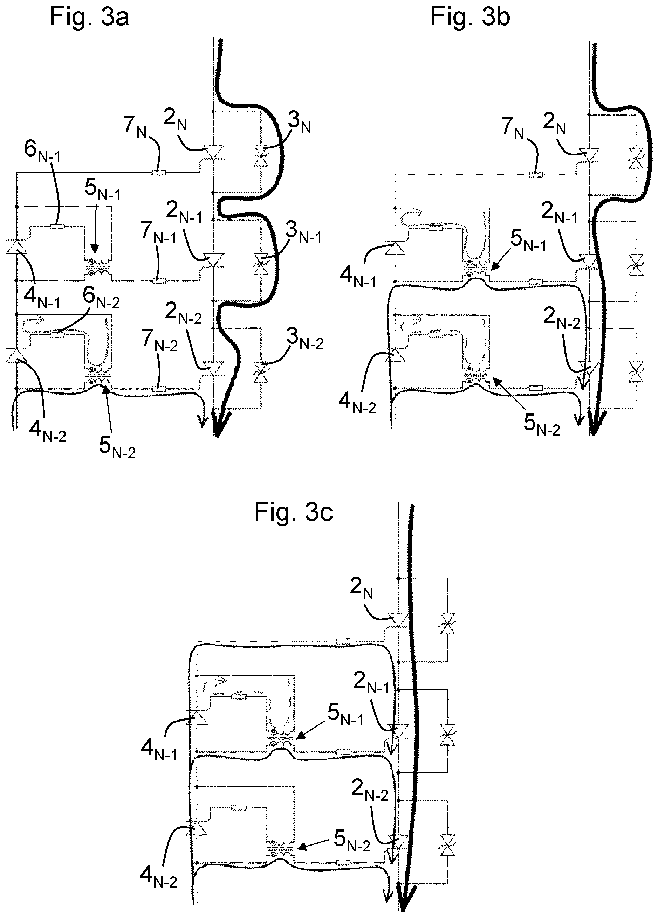

The switching device 1 further comprises N-1 driver thyristors 4₁ to 4_{N-1} for driving the N main thyristors 2₁ to 2_{N}, N-1 transformers 5₁ to 5_{N-1}, N-1 resistors 6₁ to 6_{N-1} and N resistors 7₁ to 7_{N}. The anode A of each driver thyristor 4ᵢ, where 1 ≤ i ≤ N-1, is connected to the gate G of the main thyristor 2ᵢ through successively the primary winding of the transformer 5ᵢ and the resistor 7ᵢ. The cathode K of each driver thyristor 4ᵢ is connected directly to a first terminal of the secondary winding of the transformer 5ᵢ while the gate G of each driver thyristor 4ᵢ is connected to a second terminal of the secondary winding of the transformer 5ᵢ through the resistor 6ᵢ. The cathode K of each driver thyristor 4ᵢ, where 1 ≤ i ≤ N-2, is also connected directly to the anode of the next driver thyristor 4ᵢ₊₁. The cathode of the last driver thyristor 4_{N-1} (see figures 3a to 3c) is connected to the gate of the last main thyristor 2_{N} via the resistor 7_{N}. A first output terminal 8a of a controller 8 is directly connected to the anode A of the first driver thyristor 4₁. A second output terminal 8b of the controller 8 is directly connected to the cathode K of the first main thyristor 2₁. The resistors 6₁ to 6_{N-1} may be omitted if a decrease of the current in the secondary windings is undesired.

The thyristor string 2 is in a conducting state when all main thyristors 2₁ to 2_{N} are in a conducting state (or "turned-on state" or "fired state"), i.e., when all main thyristors allow the flow of current between their anode and cathode. The thyristor string 2 is in a blocking state when one or more of the main thyristors 2₁ to 2_{N} are in a blocking state (or "turned-off state"), i.e., when one or more of the main thyristors prevent the flow of current between their anode and cathode. Another state may also occur where some of the main thyristors are in a blocking state but are bypassed by the corresponding overvoltage protection devices, as is explained below in connection with figures 3a to 3c.

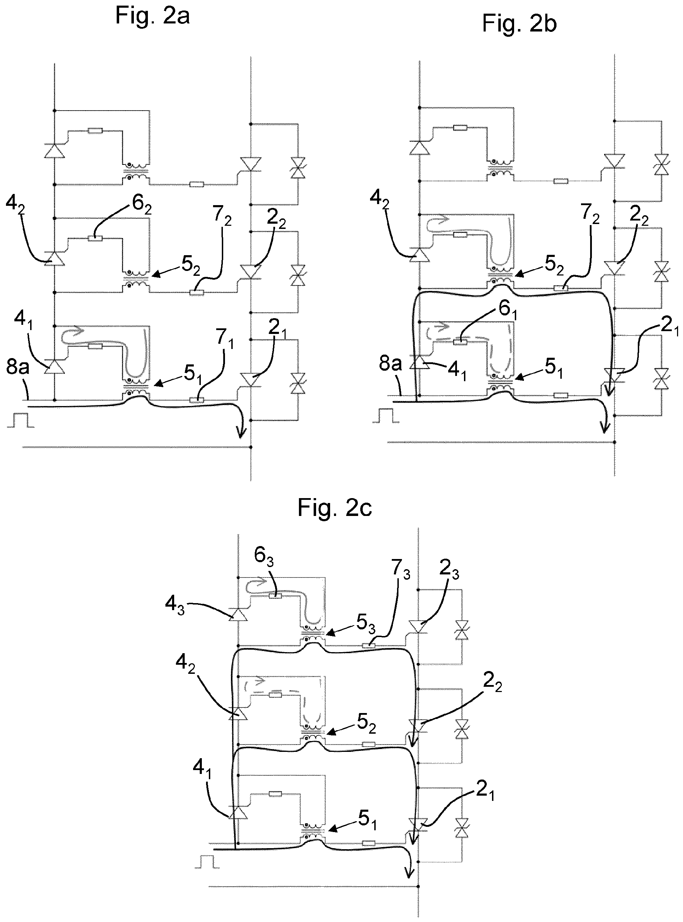

To put the thyristor string 2 into the conducting state from the state in which all main thyristors are in a blocking state, the controller 8 delivers a triggering voltage pulse. As shown in figure 2a, this causes a current to flow from the first output terminal 8a of the controller 8 through the primary winding of the first transformer 5₁ and through the resistor 7₁ to reach the gate of the first main thyristor 2₁ and fire the latter. The first main thyristor 2₁ thus changes its state from blocking state to conducting state. Simultaneously, the first transformer 5₁ reflects the firing current at its secondary winding, and the reflected current reaches the gate of the first driver thyristor 4₁, which changes its state from blocking state to conducting state.

Once both the first main thyristor 2₁ and the first driver thyristor 4₁ are fired, a firing current flows from the first output terminal 8a of the controller 8 successively through the first driver thyristor 4₁ (through its anode-cathode path), through the primary winding of the second transformer 5₂ and through the resistor 7₂ to reach the gate of the second main thyristor 2₂ and fire the latter, as shown in figure 2b. The second main thyristor 2₂ thus changes its state from blocking state to conducting state. Simultaneously, the second transformer 5₂ reflects this firing current at its secondary winding, which fires the second driver thyristor 4₂ which changes its state from blocking state to conducting state.

Once both the second main thyristor 2₂ and the second driver thyristor 4₂ are fired, a firing current flows from the cathode of the first driver thyristor 4₁ through the second driver thyristor 4₂, the primary winding of the third transformer 5₃ and the resistor 7₃ to reach the gate of the third main thyristor 2₃ to fire the latter, as shown in figure 2c. The third main thyristor 2₃ thus changes its state from blocking state to conducting state. Simultaneously, the third transformer 5₃ reflects this firing current at its secondary winding, which fires the third driver thyristor 4₃ which changes its state from blocking state to conducting state.

This process continues until all main thyristors 2₁ to 2_{N} are in their conducting state (see figures 3a to 3c).

Thus, the firing of the main thyristors 2₁ to 2_{N} occurs sequentially and the firing current for all these main thyristors originates from the controller 8 which provides the whole firing energy at the first stage of the switching device 1, i.e., at the stage comprising the first main thyristor 2₁ and the first driver thyristor 4₁. Such a cascade arrangement is simple in terms of dielectric strength and distribution of the electric field.

Moreover, no voltage across the thyristor string 2 is required in the present invention to put the main thyristors 2₁ to 2_{N} into their conducting state. This allows to check that the complete firing current can flow in all the gates of the main thyristors for diagnosis purpose, even if the thyristor string 2 has no voltage across it. The switching device 1 can be used, for example, as a test device connected in series with a resistor, the test device and the resistor being together connected in parallel with a circuit breaker, e.g., in a railway network. In such an application, the test device can be diagnosed even when the circuit breaker is closed.

The transformers 5₁ to 5_{N-1} isolate the firing/triggering path between each stage. Due to the holding effect of thyristors, each transformer 5₁ to 5_{N-1} can be chosen very small because when it saturates and stops providing current to the gate of the driver thyristor 4₁ to 4_{N-1}, the driver thyristor has already been fired and will remain in its conducting state as long as the firing current flows through its anode-cathode path.

As the main thyristors 2₁ to 2_{N} are being sequentially fired, if a voltage is present across the thyristor string 2, it will be shared between the main thyristors that are still in their blocking state. Therefore, there can be a point, in the last stages, where the voltage across each main thyristor in the blocking state becomes higher than the threshold of the corresponding overvoltage protection devices, which begin to conduct the current as illustrated in figures 3a and 3b to bypass the main thyristors and protect them. At the end of the firing sequence (figure 3c), all main thyristors are in the conducting state and the firing current can be turned off. The main thyristors remain in the conducting state until the current through the anode-cathode paths decreases to almost zero. Then, the main thyristors return to their blocking state and the voltage imbalance due to the distribution of blocking times will be limited by the overvoltage protection devices 3₁ to 3_{N}. The overvoltage protection devices 3₁ to 3_{N} also protect the main thyristors in case of lightning strike across the thyristor string 2.

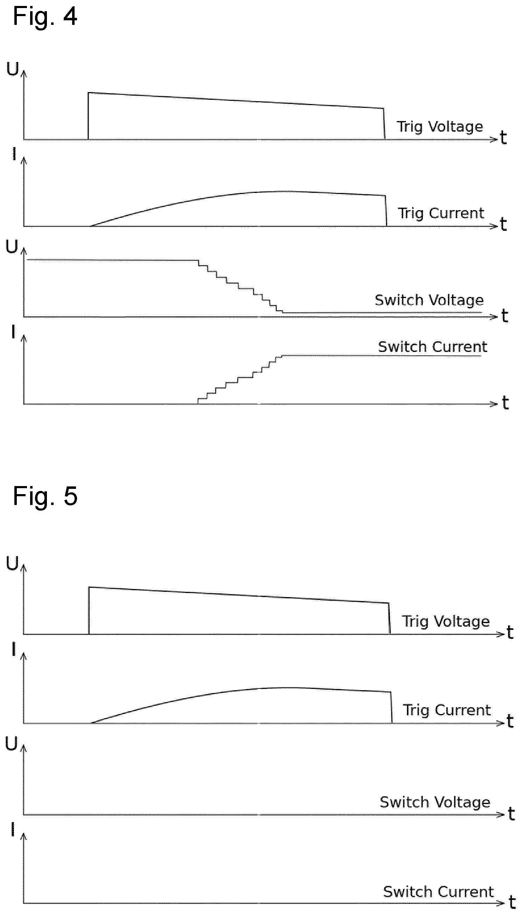

Figure 4 shows the turning-on behaviour of the switching device 1 with a resistive load. As soon as the triggering voltage ("Trig Voltage") is applied by the controller 8 to the first stage, the firing/triggering current ("Trig Current") delivered by the controller 8 increases as more and more stages of the thyristor string 2 are turned on. We can also see that at a certain point the withstand voltage of the still not conducting last main thyristors is reached, and the voltage across the thyristor string 2 ("Switch Voltage") begins to decrease in steps, each step corresponding to a new main thyristor turned on. From the same point, the current through the thyristor string 2 ("Switch Current") rises in steps until all the cascaded main thyristors 2₁ to 2_{N} are turned on. We can also see in figure 4 the dispersion of the individual turn-on time of the main thyristors across the stages. With the topology proposed by the invention, where each main thyristor is protected against voltage breakdown preferably by one or more transient voltage suppressor diodes, such a dispersion is not an issue as it can be with standard dynamic balancing using a resistor-capacitor snubber connected in parallel to each thyristor. The use of resistor-capacitor snubbers as overvoltage protection devices is however not excluded in the present invention.

By monitoring the firing current delivered by the controller 8, which is very easy at the first stage of the switching device 1, it can be determined whether all stages of the thyristor string 2 have been turned on because if one main thyristor is defective and unable to switch on, it will prevent the sequential turn-on of all next main thyristors and the firing current delivered by the controller 8 will be reduced.

It can be seen in figure 5 that when the triggering voltage is applied to the switching device 1 without any voltage across the thyristor string 2, the firing/triggering current ("Trig Current") rises in the same way as in figure 4. The proposed topology thus enables to check the correct triggering of the whole thyristor string 2 without any voltage applied to the latter.

In the case where an alternating current (AC) voltage is applied to the thyristor string 2, the diagnosis of the switching device 1 can be done without feeding current to the load, by merely testing the switching device 1 in the negative voltage period.

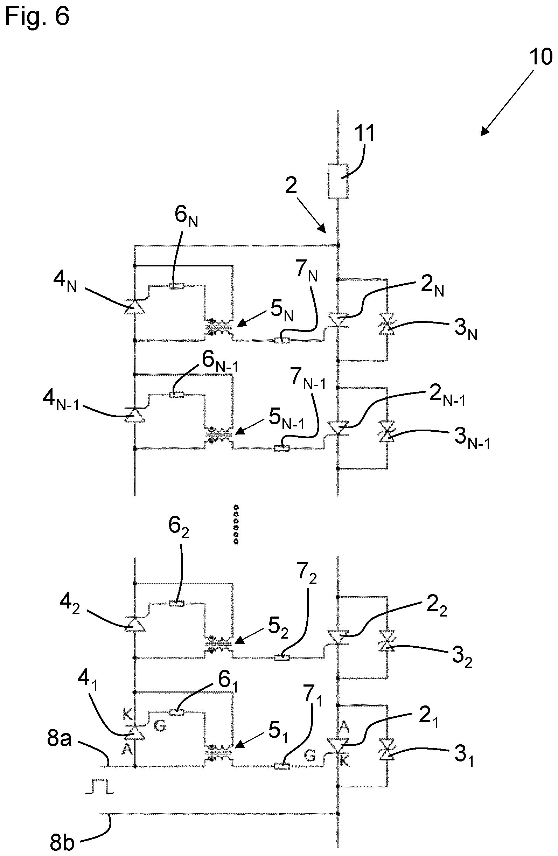

Figure 6 shows a switching device 10 according to a second embodiment of the invention. The switching device 10 comprises the same thyristor string 2, with the same N main thyristors 2₁ to 2_{N}, as the switching device 1 according to the first embodiment. The switching device 10 also comprises the same overvoltage protection devices 3₁ to 3_{N}, the same resistors 7₁ to 7_{N}, the same transformers 5₁ to 5_{N-1}, the same resistors 6₁ to 6_{N-1}, the same driver thyristors 4₁ to 4_{N-1} and the same controller 8 as the switching device 1. With respect to the first embodiment, the switching device 10 according to the second embodiment has an additional thyristor 4_{N}, an additional transformer 5_{N} and an additional resistor 6_{N}. The anode of the additional thyristor 4_{N} is directly connected to the cathode of the last driver thyristor 4_{N-1}. The cathode of the additional thyristor 4_{N} is directly connected to the anode of the last main thyristor 2_{N}, thus enabling the additional thyristor 4_{N} to inject the firing current through the last main thyristor 2_{N} and through the whole thyristor string 2. A resistor 11 is connected in series with the thyristor string 2 at the anode of the last main thyristor 2_{N}.

The use of the additional thyristor, transformer and resistor facilitates the industrial implementation of the switching device which may essentially consist of a stack of identical electronic boards, each electronic board comprising the elements 2ᵢ to 7ᵢ (with i from 1 to N) of a corresponding stage or a plurality of these. Although not used to drive a main thyristor, the additional thyristor 4_{N}, the additional transformer 5_{N} and the additional resistor 6_{N} provide the advantage that a specific electronic board for the last stage of the switching device is not required.

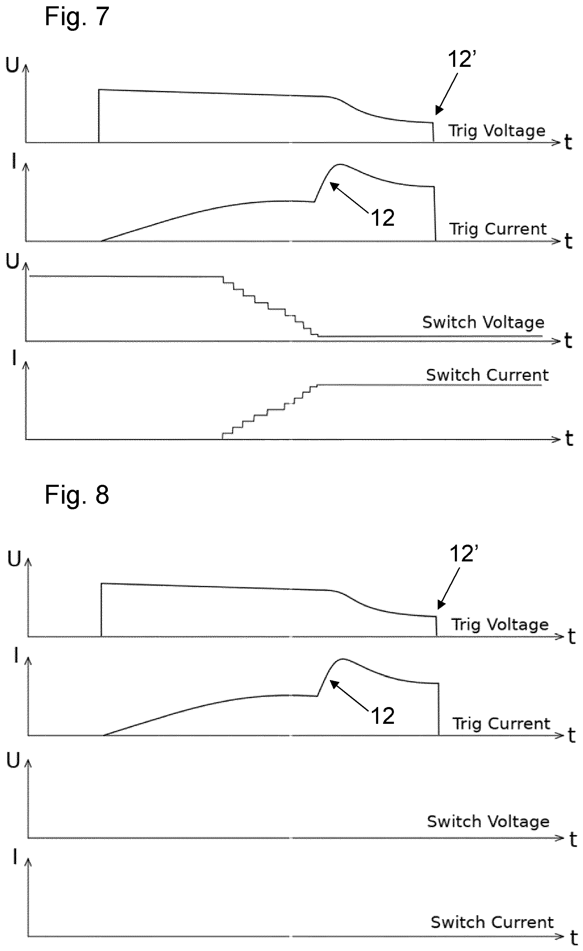

Moreover, this implementation improves the detection of the correct turn-on of the switching device, since the current drawn from the controller 8 will largely increase when all stages of the switching device are turned on. This is shown at reference number 12 in figures 7 and 8, which illustrate the turning-on behaviour of the switching device 10 in the same manner as the graphs of figures 4 and 5 for the first embodiment.

Another advantage of this implementation is that, due to the connection between the cathode of the additional thyristor 4_{N} and the anode of the last main thyristor 2_{N}, the controller 8 has its voltage limited to the forward voltage of all the driver and main thyristors in series, which enables to determine the number of thyristors in short circuit (defective thyristors). Such a determination can be done by measuring the voltage delivered by the controller 8 at the end 12' of the triggering voltage pulse (see figures 7 and 8).

The diagnosis of the switching device 10 works also if no voltage is present across the thyristor string 2, and even if the switching device is in parallel with a closed circuit breaker, due to the resistor 11 in series with the thyristor string 2 which will prevent the firing current from passing through the circuit breaker instead of through the main thyristors.

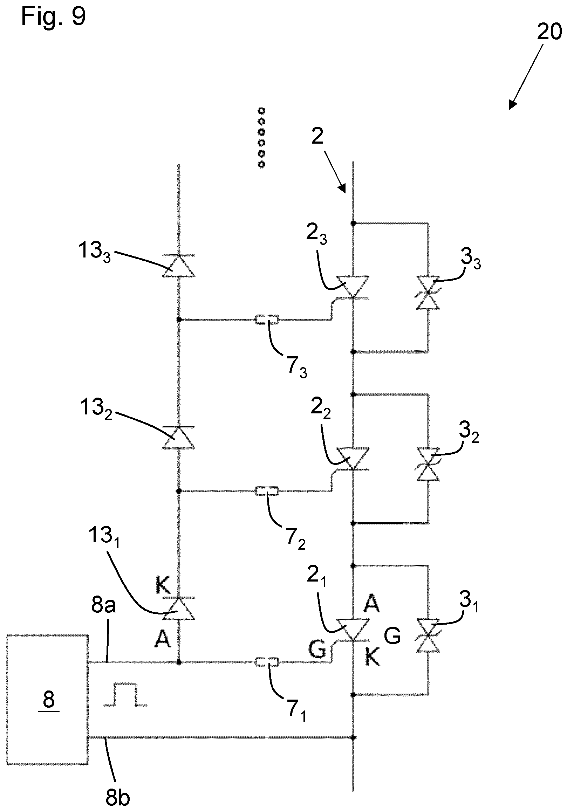

Figure 9 shows a switching device 20 according to a third embodiment not covered by the claims. As in the first and second embodiments, the switching device 20 comprises a thyristor string 2 formed by N thyristors 2₁ to 2_{N} connected in series and protected by respective overvoltage protection devices 3₁ to 3_{N}, and N resistors 7₁ to 7_{N} connected to the gate G of the thyristors 2₁ to 2_{N} respectively. A first output terminal 8a of a controller 8 is connected to the gate G of the first thyristor 2₁ via the resistor 7₁. A second output terminal 8b of the controller 8 is directly connected to the cathode K of the first thyristor 2₁. N-1 diodes 13₁ to 13_{N-1} are also provided in replacement of the elements 4₁ to 4_{N-1}, 5₁ to 5_{N-1} and 6₁ to 6_{N-1} of the first embodiment. Each diode 13ᵢ has its anode A connected to the gate G of the thyristor 2ᵢ via the resistor 7ᵢ, and has its cathode K connected to the gate G of the thyristor 2ᵢ₊₁ via the resistor 7ᵢ₊₁.

A triggering voltage delivered between the output terminals of the controller 8 causes a firing/triggering current to flow in the gate G of the first thyristor 2₁ through the first resistor 7₁ to put the first thyristor 2₁ into a conducting state. This puts the first diode 13₁ into a conducting state and a firing/triggering current then flows from the controller 8 through the first diode 13₁, the second resistor 7₂ to reach the gate of the second thyristor 2₂ and put the latter into a conducting state. The process continues until the last thyristor 2_{N} is put into its conducting state.

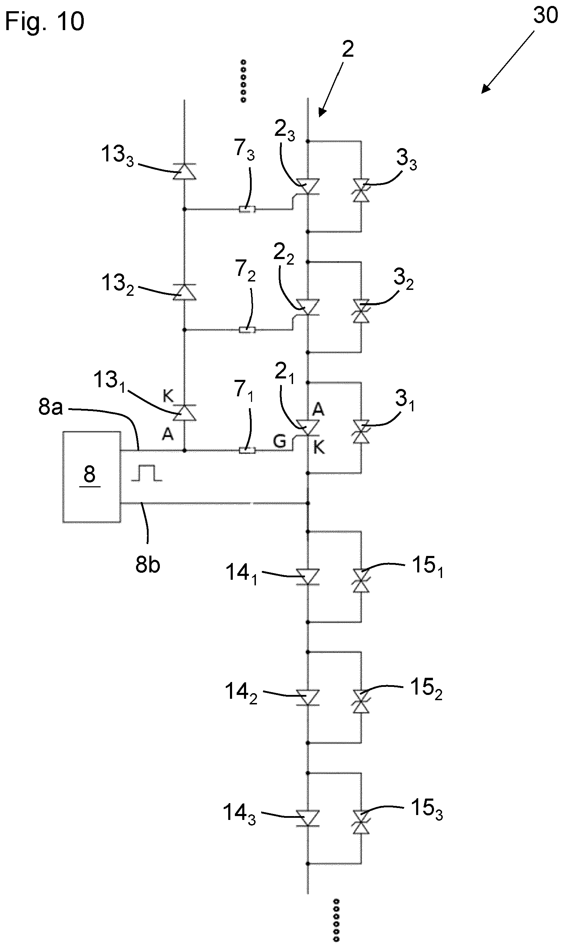

The switching device 20 is devised for direct current (DC) only. Indeed, unlike the driver thyristors 4₁ to 4_{N-1} of the first embodiment, which block any negative voltage, the diodes 13₁ to 13_{N-1} will conduct any negative voltage applied to the switching device 20 from the controller 8 to the gate of the last thyristor 2_{N}, which will see the complete negative voltage between its gate and anode and will be destroyed. Figure 10 shows a switching device 30 according to a fourth embodiment not covered by the claims, having the thyristors 2₁ to 2_{N}, the overvoltage protection devices 3₁ to 3_{N}, the resistors 7₁ to 7_{N} and the diodes 13₁ to 13_{N-1} of the third embodiment, but having an additional device that blocks negative voltages and therefore enables the switching device 30 to work also with alternating current (AC). This additional device comprises a string of serially-connected diodes 14₁ to 14_{N-1} which are reversed with respect to the diodes 13₁ to 13_{N-1} and each protected by an overvoltage protection device 15₁ to 15_{N-1} of the same type as the devices 3₁ to 3_{N}. The anode of the first diode 14₁ of the string 14₁ to 14_{N-1} is directly connected to the cathode K of the first thyristor 2₁ and to the second output terminal 8b of the controller 8. However, with respect to the first and second embodiments, the fourth embodiment has the disadvantages of being less compact and of dissipating more power when the switching device is conducting.

The present invention as described above has main semiconductor switches (the thyristors 2₁ to 2_{N}) and driver semiconductor switches (the thyristors 4₁ to 4_{N-1}). Thyristors are preferred for the main semiconductor switches and for the driver semiconductor switches because they can block a reverse voltage, they can be triggered only by a pulse and they automatically move into their blocking state when the current becomes zero. It will however be clearly apparent to one skilled in the art that other types of main semiconductor switches, such as MOSFETs, IGBTs or bipolar transistors, could be used and that other types of driver semiconductor switches, such as MOSFETs, IGBTs or bipolar transistors, could be used. In the case where the main semiconductor switches are thyristors, MOSFETs or IGBTs, for example, their gate is their control terminal, which receives a control signal such as a firing current (for thyristors) or a control voltage (for MOSFETs and IGBTs). In the case where the main semiconductor switches are bipolar transistors, for example, their base is their control terminal and receives a control or base current.

## Claims

1. Switching device (1; 10; 20; 30) comprising:
- a controller (8),
- a string (2) of main semiconductor switches (2₁ to 2_{N}) connected in series, extending from a first main semiconductor switch (2₁) to a last main semiconductor switch (2_{N}), each main semiconductor switch comprising a control terminal (G),
- driver thyristors (4₁ to 4_{N-1}) connected in series for driving the main semiconductor switches (2₁ to 2_{N}), and
- transformers (5₁ to 5_{N-1}),
wherein each driver thyristor (4₁ to 4_{N-1}) is connected by its anode (A) and its cathode (B) between the control terminals (G) of two successive main semiconductor switches of said string (2), the connection of the anode (A) of each driver thyristor (4₁ to 4_{N-1}) to the control terminal (G) of a respective main semiconductor switch (2₁ to 2_{N-1}) being through a primary winding of a respective transformer (5₁ to 5_{N-1}), a secondary winding of each transformer (5₁ to 5_{N-1}) being connected by its two terminals respectively to the gate (G) and to the cathode (K) of the respective driver thyristor (4₁ to 4_{N-1}), so that a control signal coming from the controller (8) and provided at the control terminal (G) of only the first main semiconductor switch (2₁) puts the first main semiconductor switch (2₁) into a conducting state and then sequentially puts the other main semiconductor switches (2₂ to 2_{N}) into a conducting state by sequentially putting the driver thyristors (4₁ to 4_{N-1}) into a conducting state, independently of whether a voltage is present across said string (2).

2. Switching device according to claim 1, further comprising overvoltage protection devices (3₁ to 3_{N}) associated respectively with the main semiconductor switches (2₁ to 2_{N}).

3. Switching device according to claim 2, wherein each overvoltage protection device (3₁ to 3_{N}) is operative to bypass the corresponding main semiconductor switch when a voltage across the latter reaches a predetermined threshold.

4. Switching device according to claim 2 or 3, wherein each overvoltage protection device (3₁ to 3_{N}) comprises a transient voltage suppressor diode, a Zener diode or a varistor.

5. Switching device according to any of claims 1 to 4, wherein the main semiconductor switches (2₁ to 2_{N}) are thyristors.

6. Switching device according to any of claims 1 to 5, comprising an additional thyristor (4_{N}) connected between the cathode of a last one (4_{N-1}) of the driver thyristors and the anode of the last main semiconductor switch (2_{N}) to inject through the whole string (2) a current coming from the controller (8) when all main semiconductor switches (2₁ to 2_{N}) are in the conducting state.

7. Method for testing the switching device according to any of claims 1 to 6, comprising measuring a triggering current delivered by the controller (8) to put said string (2) into a conducting state and, based on the measurement of a rise level of the triggering current, determining whether all main semiconductor switches (2₁ to 2_{N}) have been put into their conducting state.

8. Method for testing the switching device according to claim 6, comprising measuring a triggering voltage pulse delivered by the controller (8) to put said string (2) into a conducting state and, based on the measurement of a voltage delivered by the controller (8) at the end (12') of the triggering voltage pulse, determining a number of semiconductor switches in short circuit among said main and driver semiconductor switches.

9. Use of the switching device according to any of claims 1 to 6 in a railway application.

10. Use of the method according to claim 7 or 8 in a railway application.

## Patentansprüche

1. Schaltvorrichtung (1; 10; 20; 30), umfassend:
- einen Controller (8),
- eine Kette (2) von in Reihe geschalteten Haupt-Halbleiterschaltern (2₁ bis 2_{N}), die sich von einem ersten Haupt-Halbleiterschalter (2₁) bis zu einem letzten Haupt-Halbleiterschalter (2_{N}) erstreckt, wobei jeder Haupt-Halbleiterschalter einen Steuerungsanschluss (G) umfasst,
- in Reihe geschaltete Treiberthyristoren (4₁ bis 4_{N-1}) zum Ansteuern der Haupt-Halbleiterschalter (2₁ bis 2_{N}), und
- Transformatoren (5₁ bis 5_{N-1}),
wobei jeder Treiberthyristor (4₁ bis 4_{N-1}) durch seine Anode (A) und seine Kathode (B) zwischen den Steuerungsanschlüssen (G) zweier aufeinanderfolgender Haupt-Halbleiterschalter der Kette (2) verbunden ist, wobei die Verbindung der Anode (A) jedes Treiberthyristors (4₁ bis 4_{N-1}) mit dem Steuerungsanschluss (G) eines jeweiligen Haupt-Halbleiterschalters (2₁ bis 2_{N-1}) über eine Primärwicklung eines jeweiligen Transformators (5₁ bis 5_{N-1}) erfolgt, wobei eine Sekundärwicklung jedes Transformators (5₁ bis 5_{N-1}) durch ihre zwei Anschlüsse mit dem Gate (G) bzw. mit der Kathode (K) des jeweiligen Treiberthyristors (4₁ bis 4_{N-1}) verbunden ist, so dass ein Steuersignal, das von dem Controller (8) kommt und an dem Steuerungsanschluss (G) nur des ersten Haupt-Halbleiterschalters (2₁) bereitgestellt ist, den ersten Haupt-Halbleiterschalter (2₁) in einen leitenden Zustand versetzt und dann nacheinander die anderen Haupt-Halbleiterschalter (2₂ bis 2_{N}) in einen leitenden Zustand versetzt, indem die Treiberthyristoren (4₁ bis 4_{N-1}) nacheinander in einen leitenden Zustand versetzt werden, unabhängig davon, ob an der Kette (2) eine Spannung anliegt.

2. Schaltvorrichtung nach Anspruch 1, die des Weiteren Überspannungsschutzvorrichtungen (3₁ bis 3_{N}) umfasst, die jeweils den Haupt-Halbleiterschaltern (2₁ bis 2_{N}) zugeordnet sind.

3. Schaltvorrichtung nach Anspruch 2, wobei jede Überspannungsschutzvorrichtung (3₁ bis 3_{N}) dafür ausgelegt ist, den entsprechenden Haupt-Halbleiterschalter zu umgehen, wenn eine Spannung an letzterem eine zuvor festgelegte Schwelle erreicht.

4. Schaltvorrichtung nach Anspruch 2 oder 3, wobei jede Überspannungsschutzvorrichtung (3₁ bis 3_{N}) eine Suppressordiode, eine Zenerdiode oder einen Varistor umfasst.

5. Schaltvorrichtung nach einem der Ansprüche 1 bis 4, wobei die Haupt-Halbleiterschalter (2₁ bis 2_{N}) Thyristoren sind.

6. Schaltvorrichtung nach einem der Ansprüche 1 bis 5, die einen zusätzlichen Thyristor (4_{N}) umfasst, der zwischen der Kathode eines letzten (4_{N-1}) der Treiberthyristoren und der Anode des letzten Haupt-Halbleiterschalters (2_{N}) verbunden ist, um einen von dem Controller (8) kommenden Strom durch die gesamte Kette (2) zu leiten, wenn sich alle Haupt-Halbleiterschalter (2₁ bis 2_{N}) in dem leitenden Zustand befinden.

7. Verfahren zum Testen der Schaltvorrichtung nach einem der Ansprüche 1 bis 6, umfassend das Messen eines Auslösestroms, der durch den Controller (8) zugeführt wird, um die Kette (2) in einen leitenden Zustand zu versetzen, und das Bestimmen, auf der Grundlage der Messung eines Anstiegspegels des Auslösestroms, ob alle Haupt-Halbleiterschalter (2₁ bis 2_{N}) in ihren leitenden Zustand versetzt wurden.

8. Verfahren zum Testen der Schaltvorrichtung nach Anspruch 6, umfassend das Messen eines Auslösespannungsimpulses, der durch den Controller (8) zugeführt wird, um die Kette (2) in einen leitenden Zustand zu versetzen, und das Bestimmen, auf der Grundlage der Messung einer durch den Controller (8) zugeführten Spannung am Ende (12') des Auslösespannungsimpulses, einer Anzahl von Halbleiterschaltern, die kurzgeschlossen sind, unter den Haupt- und Treiber-Halbleiterschaltern.

9. Verwendung der Schaltvorrichtung nach einem der Ansprüche 1 bis 6 in einer Eisenbahnanwendung.

10. Verwendung des Verfahrens gemäß Anspruch 7 oder 8 in einer Eisenbahnanwendung.

## Revendications

1. Dispositif de commutation (1 ; 10 ; 20 ; 30), comprenant :
- un dispositif de commande (8),
- une chaîne (2) de commutateurs à semi-conducteur principaux (2₁ à 2_{N}) connectés en série, s'étendant d'un premier commutateur à semi-conducteur principal (2₁) à un dernier commutateur à semi-conducteur principal (2_{N}), chaque commutateur à semi-conducteur principal comprenant une borne de commande (G),
- des thyristors de commande (4₁ à 4_{N-1}) connectés en série pour commander les commutateurs à semi-conducteur principaux (2₁ à 2_{N}) , et
- des transformateurs (5₁ à 5_{N-1})
dans lequel chaque thyristor de commande (4₁ à 4_{N-1}) est connecté par son anode (A) et sa cathode (B) entre les bornes de commande (G) de deux commutateurs à semi-conducteur principaux successifs de ladite chaîne (2), la connexion de l'anode (A) de chaque thyristor de commande (4₁ à 4_{N-1}) à la borne de commande (G) d'un commutateur à semi-conducteur principal respectif (2₁ à 2_{N-1}) se faisant par l'intermédiaire d'un enroulement primaire d'un transformateur respectif (5₁ à 5_{N-1}), un enroulement secondaire de chaque transformateur (5₁ à 5_{N-1}) étant connecté par ses deux bornes respectivement à la grille (G) et à la cathode (K) du thyristor de commande respectif (4₁ à 4_{N-1}), de sorte qu'un signal de commande provenant du dispositif de commande (8) et fourni au niveau de la borne de commande (G) uniquement du premier commutateur à semi-conducteur principal (2₁) met le premier commutateur à semi-conducteur principal (2₁) dans un état conducteur, puis met séquentiellement les autres commutateurs à semi-conducteur principaux (2₂ à 2_{N}) dans un état conducteur en mettant séquentiellement les thyristors de commande(4₁ à 4_{N}-₁) dans un état conducteur, indépendamment de la présence ou non d'une tension aux bornes de ladite chaîne (2).

2. Dispositif de commutation selon la revendication 1, comprenant en outre des dispositifs de protection contre les surtensions (3₁ à 3_{N}) associés respectivement aux commutateurs à semi-conducteur principaux (2₁ à 2_{N}).

3. Dispositif de commutation selon la revendication 2, dans lequel chaque dispositif de protection contre les surtensions (3₁ à 3_{N}) fonctionne pour contourner le commutateur à semi-conducteur principal correspondant lorsqu'une tension aux bornes de ce dernier atteint un seuil prédéterminé.

4. Dispositif de commutation selon la revendication 2 ou 3, dans lequel chaque dispositif de protection contre les surtensions (3₁ à 3_{N}) comprend une diode de suppression de tension transitoire, une diode Zener ou une varistance.

5. Dispositif de commutation selon l'une quelconque des revendications 1 à 4, dans lequel les commutateurs à semi-conducteur principaux (2₁ à 2_{N}) sont des thyristors.

6. Dispositif de commutation selon l'une quelconque des revendications 1 à 5, comprenant un thyristor supplémentaire (4_{N}) connecté entre la cathode d'un dernier (4_{N-1}) des thyristors de commande et l'anode du dernier commutateur à semi-conducteur principal (2_{N}) pour injecter à travers la chaîne entière (2) un courant provenant du dispositif de commande (8) lorsque tous les commutateurs à semi-conducteur principaux (2₁ à 2_{N}) sont dans l'état conducteur.

7. Procédé pour tester le dispositif de commutation selon l'une quelconque des revendications 1 à 6, comprenant la mesure d'un courant de déclenchement délivré par le dispositif de commande (8) pour mettre ladite chaîne (2) dans un état conducteur et, sur la base de la mesure d'un niveau de montée du courant de déclenchement, la détermination de si tous les commutateurs à semi-conducteur principaux (2₁ à 2_{N}) ont été mis dans leur état conducteur.

8. Procédé pour tester le dispositif de commutation selon la revendication 6, comprenant la mesure d'une impulsion de tension de déclenchement délivrée par le dispositif de commande (8) pour mettre ladite chaîne (2) dans un état conducteur et, sur la base de la mesure d'une tension délivrée par le dispositif de commande (8) à la fin (12') de l'impulsion de tension de déclenchement, la détermination d'un nombre de commutateurs à semi-conducteur en courtcircuit parmi lesdits commutateurs à semi-conducteur principaux et de commande.

9. Utilisation du dispositif de commutation selon l'une quelconque des revendications 1 à 6 dans une application ferroviaire.

10. Utilisation du procédé selon la revendication 7 ou 8 dans une application ferroviaire.
